# EUROPÄISCHE PATENTSCHRIFT

(11) **EP 1 016 213 B1**
(45) Veröffentlichungstag und Bekanntmachung des Hinweises auf die Patenterteilung: **05.06.2002**
(21) Anmeldenummer: 98925411.5
(22) Anmeldetag: 19.03.1998
(51) Int. Cl.: H03K 17/082, H03K 17/16

(54) **ÜBERTEMPERATUR-SCHUTZSCHALTUNG**
CIRCUIT FOR PROTECTION FROM EXCESS TEMPERATURE
CIRCUIT DE PROTECTION EN CAS DE TEMPERATURE SUPERIEURE A LA NORMALE

(30) Priorität: 28.05.1997 DE 19722300
(43) Veröffentlichungstag der Anmeldung: 05.07.2000
(73) Patentinhaber: ROBERT BOSCH GMBH, 70442 Stuttgart (DE)
(72) Erfinder: MICHEL, Hartmut, D-72762 Reutlingen (DE); PLUNTKE, Christian, D-72379 Hechingen (DE); THANNER, Manfred, D-72827 Wannweil (DE); BIRECKOVEN, Bernd, D-72127 Kusterdingen (DE)
(86) Internationale Anmeldenummer: DE9800809
(87) Internationale Veröffentlichungsnummer: WO9854838

(56) Entgegenhaltungen:
- DE-A- 19 519 477
- US-A- 4 345 218
- US-A- 5 045 964
- US-A- 5 418 674

## Beschreibung

### Stand der Technik

Die Erfindung geht aus von einer integrierten Schaltung mit einem Leistungstransistor und einer temperaturabhängig arbeitenden, mit dem Leistungstransistor thermisch gekoppelten Schaltungsanordnung nach der Gattung des Hauptanspruchs. Es ist schon eine solche Übertemperatur-Schutzschaltung bekannt (DE 195 19 477), bei der bei hohen Temperaturen des Leistungstransistors der Leistungstransistor kontinuierlich abgeregelt wird. Liegt die zulässige Bodentemperatur eines oberflächenmontierten Leistungstransistors deutlich unter der Abschaltschwelle der Übertemperatur-Sicherung, so muss ein einmaliges Hineinlaufen in diesen Bereich durch hohe Eigenerwärmung noch nicht zum Aufschmelzen der bodenseitigen Lotschicht führen, ein repetierlicher Betrieb aber sehr wohl. Daher ist es wünschenswert, entsprechende Abschaltstrategien vorzusehen. Weiterhin ist die Druckschrift US 5,045,964 bekannt, wo ein Schaltkreis in einem Zündungssystem offenbart wird. Weiterhin offenbart dieses Dokument eine Schaltungsanordnung zur Abscheidung eines Leistungstransistors bei Überschreitung einer Temperaturschwelle. Die Schaltungsanordnung enthält eine Verrastungsschaltung, die nach Erhalt eines Temperatursignals den Leistungstransistor abschaltet.

Weiterhin ist die Druckschrift US 5,610,792 bekannt, die eine Schutzschaltung offenbart, in der eine Hysterese durch zwei Verrastungsschaltungen gewährleistet wird.

### Vorteile der Erfindung

Die erfindungsgemäße integrierte Schaltung mit den Merkmalen des Hauptanspruchs hat demgegenüber den Vorteil, eine Übertemperatursicherung für Leistungstransistoren bei Temperaturen um 200° C mit hoher Präzision zu gewährleisten, die einerseits das Bauelement sicher schützt, andererseits seinen Einsatzbereich nicht einengt und für niedrige Bodentemperaturen (bei Oberflächenmontage) geeignet ist. Das Vorsehen einer ersten Verrastungsschaltung bewirkt eine sichere Funktionsweise der integrierten Schaltung auch bei variablen induktiven Lasten. Es kann also die gleiche Schutzschaltung für verschieden dimensionierte induktive Lasten verwendet werden, die über den zu schützenden Leistungstransistor betrieben werden.

Durch die in den abhängigen Ansprüchen aufgeführten Maßnahmen sind vorteilhafte Weiterbildungen und Verbesserungen der im Hauptanspruch angegebenen integrierten Schaltung möglich. Besonders vorteilhaft ist, wenn, nachdem die Bauelementtemperatur, beispielsweise die Temperatur des Basis-Kollektor-Übergangs des Leistungstransistors, eine obere Temperaturschwelle überschritten hat und die erste Verrastungsschaltung den Leistungstransistors abgeschaltet hat, nach Unterschreiten der oberen Temperaturschwelle der Leistungstransistor erst wieder angesteuert werden kann, nachdem ein Flankenwechsel am Basisanschluß erfolgt ist. Dies gewährleistet insbesondere im Störfall langer Einschaltzeiten, also langer Zeiten der Ansteuerung des Leistungstransistors über den Basisanschluß, daß die Bodentemperatur niemals eine obere Grenze überschreitet, die unterhalb der oberen Temperaturschwelle der Bauelementtemperatur liegt.

Weist die integrierte Schaltung zusätzlich einen Funkenunterdrückungsteil auf, so kann in vorteilhafter Weise im Falle einer Übertemperaturabschaltung ein bei induktiven Lasten auftretender Abschaltfunke unterdrückt werden. Ein solcher Abschaltfunke z.B. an der Sekundärwicklung einer Zündspule würde ansonsten die Betriebssicherheit der Schaltung gefährden, denn insbesondere bei Kraftfahrzeug-Anwendungen im Bereich der Zündung dürfen Zündimpulse nur zu definierten Zeitpunkten auftreten.

Das Vorsehen eines Ansteuertransistors ermöglicht in einfacher Weise die Ankopplung der Verrastungschaltung an den Leistungstransistor.

Der Vorteil einer zweiten Verrastungsschaltung besteht insbesondere bei hochfrequenten Ansteuerungen des Leistungstransistors darin, erst dann ein Wiedereinschalten des Leistungstransistors nach einer Übertemperaturabschaltung zu ermöglichen, wenn die Bauelementtemperatur eine untere Temperaturschwelle unterschritten hat.

Das Unterschreiten der unteren Temperaturschwelle kann in vorteilhafter Weise durch einen zweiten Temperatursensor detektiert werden, der beispielsweise in einem unteren Temperaturbereich optimiert ist.

In vorteilhafter Weise ist der Ausgang der ersten Verrastungsschaltung mit der Basis eines Transistors verbunden, dessen Kollektorstrom beispielsweise über den Ansteuertransistor eine Änderung des Basisstroms des Leistungstransistors auslöst.

Erste und/oder zweite Verrastungsschaltung sind in einfacher Weise als RS-Flip-Flop-Schaltung realisierbar.

Ist der erste Temperatursensor als Sensortransistor ausgestaltet, dessen Basis-Emitter-Strecke mit einem temperaturabhängigen Sensorwiderstand mit positivem Temperaturkoeffizienten beschaltet ist, so sind hohe Bauelementtemperaturen von bis über 200° C sicher detektierbar.

### Zeichnung

Ausführungsbeispiele der Erfindung sind in der Zeichnung dargestellt und in der nachfolgenden Beschreibung näher erläutert. Figur 1 beziehungsweise la zeigt eine integrierte Schaltung nach dem Stand der Technik. Figur 2 zeigt ein erstes Ausführungsbeispiel der Erfindung, Figur 3 ein Zeitdiagramm eines Basissignals, Figur 4 ein weiteres Ausführungsbeispiel der Erfindung.

### Beschreibung der Ausführungsbeispiele

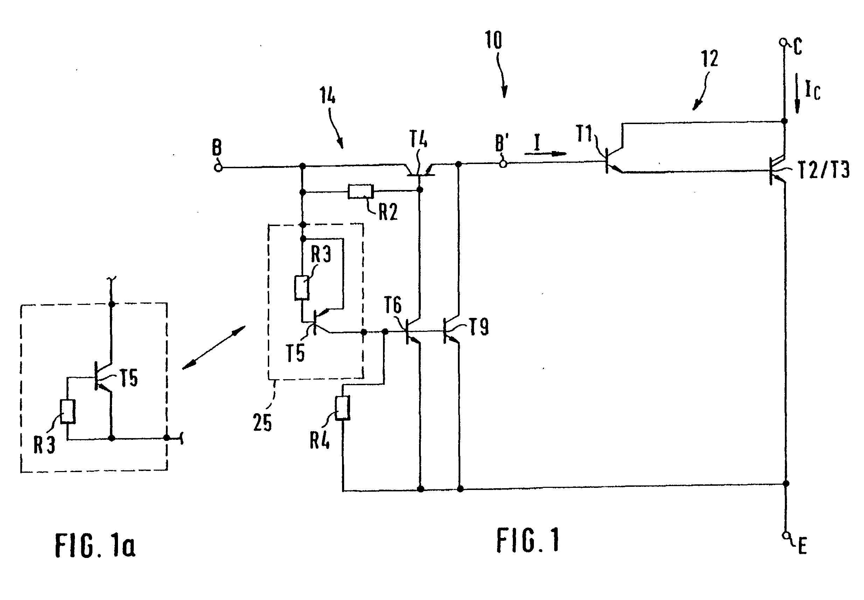

Figur 1 zeigt eine insgesamt mit 10 bezeichnete integrierte Schaltung nach dem Stand der Technik. Die integrierte Schaltung 10 weist einen Leistungstransistor 12 und eine Schaltungsanordnung 14 auf, die im einzelnen folgendermaßen verschaltet sind. Die integrierte Schaltung 10 weist einen Kollektoranschluß C, einen Basisanschluß B sowie einen Emitteranschluß E auf. Der Leistungstransistor 12 wird von den Transistoren T1, T2 und T3 gebildet, die in einer Darlington-Anordnung verschaltet sind. Die Transistoren T1, T2 und T3 sind als NPN-Transistoren ausgestaltet. Die Schaltungsanordnung 14 weist die Transistoren T4, T5 und T6 auf, wobei der Transistor T5 als PNP oder NPN-Transistor und die Transistoren T4 und T6 als NPN-Transistor ausgebildet sind. Der Basisanschluß B ist mit dem Kollektor des Transistors T4 verbunden. Der Emitter des Transistors T4 ist mit der Basis des Transistors T1 verbunden. Der Kollektor der Transistoren T1, T2 und T3 ist mit dem Kollektoranschluß C verbunden. Der Emitter des Transistors T1 ist mit der Basis des Transistors T2, der Emitter des Transistors T2 mit der Basis des Transistors T3 verbunden. Der Emitter des Transistors T3 ist mit dem Emitteranschluß E verbunden. Die Basis des Transistors T5 ist über einen Widerstand R3 mit dem Emitter des Transistors T5 verbunden. Widerstand R3 und Transistor T5 stellen zusammen einen ersten Temperatursensor 25 dar. Der Widerstand R3 ist als temperaturabhängiger Widerstand beispielsweise mit einem positiven Temperaturkoeffizenten ausgebildet. Der Kollektor des Transistors T4 ist weiterhin mit dem Emitter des Transistors T5 im Falle eines PNP-Transistors, sonst mit dem Kollektor des Transistors T5 im Falle eines NPN-Transistors (Figur 1a) und über den Widerstand R2 mit dem Kollektor des Transistors T6 verbunden. Der Kollektor des Transistors T6 ist weiterhin mit der Basis des Transistors T4 verbunden. Der Kollektor des Transistors T5 ist im Falle des PNP-Transistors, sonst der Emitter des Transistors T5 im Falle des NPN-Transistors, einerseits mit der Basis des Transistors T6 und andererseits über den Widerstand R4 mit dem Emitteranschluß E verbunden. Der Emitter des Transistors T6 ist ebenfalls mit dem Emitteranschluß E verbunden. Die Basis eines Transistors T9 ist mit der Basis des Transistors T6 verbunden. Der Kollektor des Transistors T9 ist mit dem Emitter des Transistors T4 verbunden, der Emitter des Transistors T9 ist mit dem Emitteranschluß E der integrierten Schaltung verbunden.

Die integrierte Schaltung 10 übt folgende Funktion aus. Während des bestimmungsgemäßen Einsatzes der integrierten Schaltung 10 kann mittels des Leistungstransistors 12 zwischen dem Kollektoranschluß C und dem Emitteranschluß E eine Last geschaltet werden, beispielsweise ist am Kollektoranschluß C eine als Spartransformator ausgeführte Zündspule angeschlossen. Die Ansteuerung des Leistungstransistors 12 erfolgt über den zwischen dem Basisanschluß B und der Basis des Transistors T1 "längs" geschalteten Transistor T4. Über den Transistor T4 kann somit der Basisstrom I des Leistungstransistors 12 beeinflußt werden. Der Temperatursensor 25 speist einen mit der Temperatur steigenden Sperrstrom in den Widerstand R4 ein. Je höher die Temperatur, desto stärker wird der Transistor T6 angesteuert und um so mehr wird die Ansteuerung des Transistors T4 zurückgenommen, so daß auch bei einem am Basisanschluß B anliegenden Steuersignal der Leistungstransistor 12 mit steigender Temperatur zunehmend abgeregelt wird. Trotz eines abgeregelten Leistungstransistors 12 steht am Kollektor des Transistors T4 die Quellenspannung der Basisversorgung der integrierten Schaltung 10 an, somit wird erreicht, daß trotz eines abgeregelten Leistungstransistors 12 die Schaltungsanordnung 14 und damit der als thermische Sensorelement geschaltete Transistor T5 eine ausreichend große treibende Spannung zur Verfügung hat. Durch die Wahl des Widerstands R3 und des Transistors T5 ergibt sich die spezifische Art der thermischen Abregelung, die beispielsweise erst bei sehr hohen Temperaturen, die über 200° Celsius liegen können, einsetzt. Der Transistor T9 wird ebenfalls durch den Sperrstrom des Transistors T5 angesteuert und verbessert die Abregelung des Leistungstransistors 12 insbesondere bei hohen Temperaturen über 200° C.

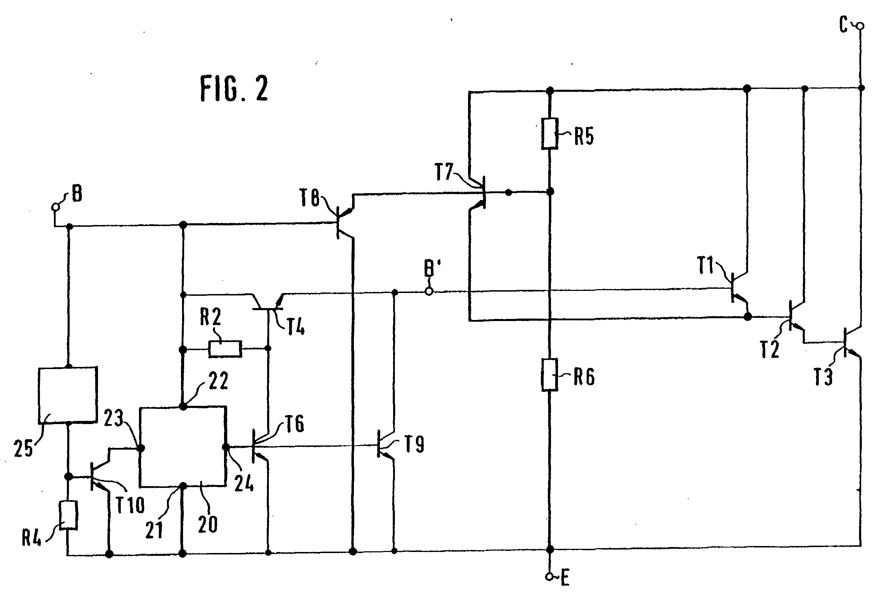

Figur 2 zeigt ein erstes Ausführungsbeispiel der Erfindung. Gleiche Elemente wie in Figur 1 sind mit gleichen Bezugszeichen versehen und werden nicht nochmals beschrieben. Die Schaltung nach Figur 2 weist eine erste Verrastungsschaltung 20 auf, die einen Eingang 23, einen Ausgang 24, einen ersten Spannungsanschluß 21 und einen zweiten Spannungsanschluß 22 besitzt. Der erste Spannungsanschluß 21 ist mit dem Emitteranschluß E der integrierten Schaltung verbunden, der zweite Spannungsanschluß 22 ist mit dem Basisanschluß B der integrierten Schaltung verbunden. Im Gegensatz zur Figur 1 ist der vom Basisanschluß der integrierten Schaltung abgewandte Anschluß des Temperatursensors 25 nicht direkt mit der Basis des Transistors T6 verbunden, sondern an der Basis eines Transistors T10 angeschlossen. Der Emitter des Transistors T10 ist mit dem Emitteranschluß E der integrierten Schaltung verbunden, der Kollektor des Transistors T10 ist mit dem Eingang 23 der ersten Verrastungsschaltung 20 verbunden. Die Basis des Transistors T6 ist jetzt mit dem Ausgang 24 der ersten Verrastungsschaltung 20 verbunden. Die Schaltung weist ferner ein Funkenunterdrückungsteil (T8, T7, R5, R6) auf. Der Kollektorund der Emitteranschluß C bzw. E sind dabei über einen Spannungsteiler mit den beiden Widerständen R5 und R6 miteinander verbunden. Der Abgriff des Spannungsteilers ist mit der Basis des NPN-Transistors T7 verbunden, dessen Kollektor wiederum mit dem Kollektoranschluß C verbunden ist und dessen Emitter mit dem Emitter des Teiltransistors T1 des Leistungstransistors verbunden ist. Die Basis des Transistors T7 ist außerdem mit dem Emitter des PNP-Transistors T8 verbunden, dessen Kollektor mit dem Emitteranschluß E der integrierten Schaltung in Verbindung steht und der über ein am Basisanschluß B anliegendes Steuersignal angesteuert wird. Mit B' ist in Figur 2 der Basisanschluß des Leistungstransistors gekennzeichnet. Am Kollektoranschluß C ist beispielsweise eine induktive Last angeschlossen, und zwischen dem Kollektoranschluß und dem Emitter des zweiten Teiltransistors T2 ist wahlweise zusätzlich eine Zenerdiode geschaltet, wobei der Minuspol der Zenerdiode am Kollektoranschluß anliegt. Die erste Verrastungschaltung 20 ist in einer bevorzugten Ausführungsform als RS-Flip-Flop-Schaltung ausgeführt, wobei die Spannungsversorgung des Flip-Flops der ersten Verrastungschaltung über den ersten und zweiten Spannungsanschluß 21 beziehungsweise 22 durch die Basis-Emitter-Spannung der integrierten Schaltung gegeben ist und der zweite Spannungsanschluß 22 mit dem Reset-Eingang des RS-Flip-Flops, der Eingang 23 mit dem Set-Eingang des RS-Flip-Flops und der Ausgang 24 mit dem Q-Ausgang des RS-Flip-Flops verbunden ist.

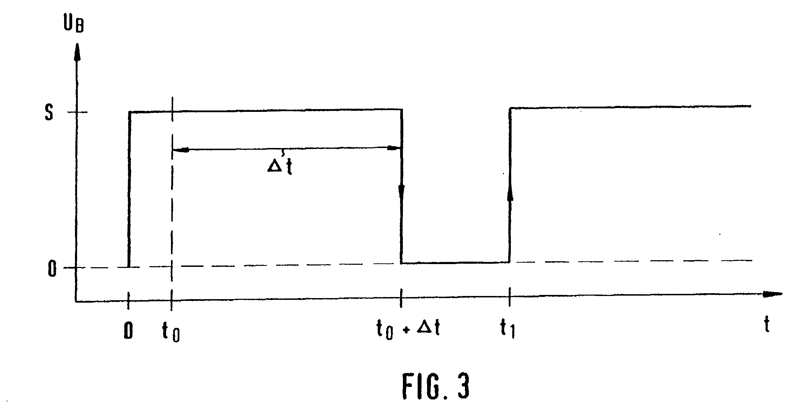

Zum Verständnis der Funktionsweise der Schaltung nach Figur 2 ist in Figur 3 beispielhaft ein am Basisanschluß B anliegendes Basissignal U_{B}, das als Steuersignal für den Leistungstransistor und gleichzeitig für die erste Verrastungsschaltung eingesetzt wird, dargestellt. Das Basissignal U_{B} wechselt zwischen den Werten S und beispielsweise Null und liegt im Zeitraum zwischen dem Zeitpunkt t=0 und t=t₀ + Δt auf S, zwischen t₀ + Δt und t₁ auf Null. t₀ markiert dabei den Zeitpunkt der Übertemperaturabschaltung durch die erste Verrastungsschaltung 20 und Δt den minimalen zur Abkühlung zur Verfügung stehenden Zeitraum. t₀ + Δt ist beispielsweise eine lange Einschaltzeit, die ohne Übertemperaturabschaltung mit der Verrastungsschaltung 20 zu einer Schädigung der Schaltung führen kann. Mit t₁ ist der Zeitpunkt des positiven Flankenwechsels markiert, t₀ + Δt markiert den Zeitpunkt des negativen Flankenwechsels. Ist nun die Schaltung in einem Bauelement integriert, das auf einer Oberfläche montiert ist, so muß im Betrieb gewährleistet sein, daß eine zulässige Bodentemperatur nicht überschritten wird, beispielsweise 150°C, damit es nicht zu Schädigungen beispielsweise der Leiterplatte, auf der das Bauelement montiert ist, oder sogar zum Ablöten kommt. Diese Temperaturgrenze bedeutet nicht, daß die integrierte Schaltung selber diese Temperatur nicht überschreiten dürfte. Erst oberhalb einer oberen Temperaturschwelle Tⱼₘₐₓ, die größer ist als die maximal zulässige Bodentemperatur, muß die integrierte Schaltung abgeschaltet werden, damit weder das Bauelement selbst noch die Leiterplatte, auf der das Bauelement befestigt ist, beschädigt werden. Ferner wird die Gefahr des Ablötens des Bauelements von der Leiterplatte beseitigt. Überschreitet also die Bauelementtemperatur Tⱼ die obere Temperaturschwelle T_{j,max}, so liefert der erste Temperatursensor 25 einen so großen Strom, daß der Transistor T10 angesteuert wird und das RS-Flip-Flop der ersten Verrastungsschaltung 20 an seinem Ausgang 24 von seiner Vorzugslage 0 auf 1 gesetzt wird. Dadurch werden die Transistoren T6 und T9 aktiviert und die Ansteuerung des Ansteuertransistors T4 zurückgenommen, so daß der Leistungstransistor abgeschaltet wird. Unterschreitet die Bauelementtemperatur Tⱼ die obere Temperaturschwelle, so bleibt zunächst der Leistungstransistor abgeschaltet, da das RS-Flip-Flop trotz veränderten Eingangssignals am Eingang 23 das Signal am Ausgang 24 unverändert läßt. Erst wenn nach dem Zeitpunkt t₀ der Übertemperaturabschaltung ein Flankenwechsel erfolgt, also im Beispiel der Figur 3 die Ansteuerung am Basisanschluß B der integrierten Schaltung zurückgenommen wird, wird das RS-Flip-Flop zurückgesetzt und bei einem erneuten Flankenwechsel zum Zeitpunkt t₁ wird der Leistungstransistor erneut angesteuert. Durch die erste Verrastungsschaltung 20 wird gewährleistet, daß insbesondere im Falle langer Einschaltzeiten t₀ + Δt, die einen Störfall darstellen, der Leistungstransistor eine genügend lange Abkühlzeit Δt zur Verfügung hat. Bei einer kontinuierlichen Abregelung wie in der Schaltung nach Figur 1 hingegen ist insbesondere im Falle langer Einschaltzeiten der integrierten Schaltung trotz bei ansteigender Temperatur kleinerer Ansteuerung des Leistungstransistors in Folge der thermischen Abregelung nicht gewährleistet, daß die Bödentemperatur unterhalb eines zulässigen Grenzwerts von beispielsweise 150° C bleibt, da trotz einer Abregelung eine weitere Erwärmung des Bodens erfolgen kann und sich die Bodentemperatur immer mehr der Bauelementtemperatur annähert, die ja über der maximal zulässigen Bodentemperatur liegen kann.

Das temperaturbedingte Abschalten führt beim Einsatz als Schalter von induktiven Lasten in Zündungsapplikationen zu Spannungsüberhöhungen am Kollektoranschluß C, die zu einem nicht vorhersehbaren Funken führen können. Daher muß ein automatisches Umschalten des Klammerspannungsniveaus zwischen Kollektor und Emitteranschluß der integrierten Schaltung von üblichen 400 Volt auf Werte von typisch 30 Volt erfolgen. Diese Abschaltfunkenunterdrückung mittels des Funkenunterdrückungsteils (T8, T7, R5, R6) wird durch das nach Ausschalten des Leistungstransistors durch die erste Verrastungsschaltung weiterhin anstehende Steuersignal am Basisanschluß freigegeben und bleibt solange aktiv, bis die Spulenenergie durch Aufsteuerung des Dreifach-Darlington-Transistors als Verlustleistung bei einer Spannung, die durch das Teilerverhältnis R5 zu R6 gegeben ist (z.B. 30 V), umgesetzt wurde. Im normalen Betrieb ist der Funkenunterdrückungsteil gesperrt und die für Zündungsapplikationen übliche Klammerspannung (z.B. 400 V, wenn beispielsweise eine Zenerdiode zwischen dem Kollektoranschluß C und dem Emitter von T2 geschaltet ist) steht zur Verfügung. Im einzelnen funktioniert die Abschaltfunkenunterdrückung folgendermaßen:
Im Falle der Übertemperaturabschaltung durch die erste Verrastungsschaltung 20 liegt am Basisanschluß B weiterhin ein Steuersignal an. Aufgrund der magnetischen Induktion in der Zündspule steigt die Spannung am Kollektoranschluß C, mithin die am Widerstand R6 abfallende Spannung, bis der Transistor T7 angesteuert wird, wodurch über die Kollektor-Emitter-Strecke des Transistors T7 der Leistungstransistor an der Basis des Transistors T2 aufgesteuert wird; im Störfall der Übertemperaturabschaltung wird also über den Funkenunterdrückungsteil der Leistungstransistor an einer zweiten Basis betrieben. Durch geeignete Wahl der Widerstände R5 und R6 wird dabei gewährleistet, daß die Spannung am Kollektoranschluß C beispielsweise 30 Volt im Störfall der Übertemperaturabschaltung nicht überschreitet. Liegt hingegen der Basisanschluß B der integrierten Schaltung auf Masse (Eingang "low"), so ist der Transistor T8 leitend geschaltet und die Basis des Transistors T7 liegt über dem Transistor T8 ungefähr auf Masse. Das bedeutet, daß der Transistor T7 in diesem Falle gesperrt ist und der Leistungstransistor nicht über T7 angesteuert werden kann, d.h. bei gewollter Abschaltung am Eingang B ist der Funkenunterdrückungsteil blockiert. Liegt aber ein Steuersignal am Basisanschluß B der integrierten Schaltung an, so ist der Transistor T8 gesperrt. Die Basis des Transistors T7 wird nicht auf Masse gelegt. Im Normalbetrieb hat der Kollektoranschluß ein niedriges Potential und T7 bleibt gesperrt. Im Falle der Übertemperaturabschaltung durch die erste Verrastungsschaltung 20 jedoch wird der Leistungstransistor über den Teiltransistor T1 abgeschaltet und das Potential am Kollektoranschluß C steigt an, so daß schließlich der Leistungstransistor zur Abschaltfunkenunterdrückung und Abbau der Spulenenergie über die Basis des Teiltransistors T2 aufgesteuert wird, wenn das Potential des Kollektoranschlusses beispielsweise 30 Volt überschritten hat. Der Vorteil der Schaltung nach Figur 2 liegt also in einem sicheren Schutz für oberflächenmontierbare Leistungsbauelemente gegen Lotzerrüttung und Auslöten im Störfall langer Einschaltzeiten, bei denen die kurzzeitig zulässige Bauelementtemperatur T_{j,max} höher ist als die maximal zulässige Bodentemperatur. Die Abschaltung mit einer nur geringfügigen Spannungsüberhöhung am Kollektor des Leistungstransistors bei Verwendung als Schalter für induktive Lasten verhindert in Zündapplikationen sicher eine ungewollte Funkenbildung. Die Freigabe des Bauelements erfolgt erst mit einem Flankenwechsel am Basisanschluß B. Somit wird die Endstufe nicht gleich wieder nach dem Unterschreiten der oberen Temperaturschwelle aufgesteuert.

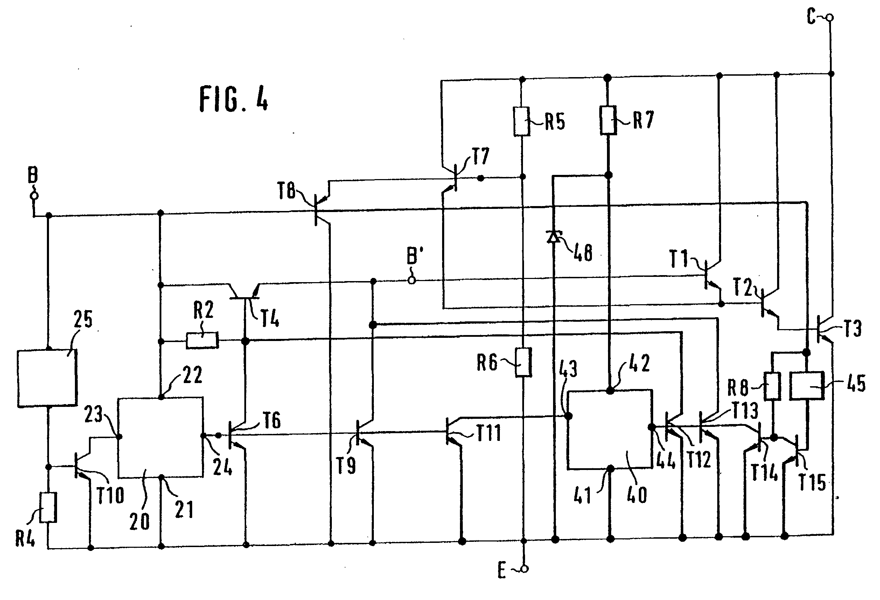

Figur 4 zeigt ein weiteres Ausführungsbeispiel der Erfindung. Gegenüber der Figur 2 weist die Schaltung nach Figur 4 zusätzliche Schaltungsteile auf, die im folgenden beschrieben werden. Es ist eine zweite Verrastungsschaltung 40 vorgesehen, die über ihren weiteren Eingang 43 mit dem Kollektor des Transistors T11 verbunden ist, dessen Emitter mit dem Emitteranschluß der integrierten Schaltung und dessen Basis mit dem Ausgang 24 der ersten Verrastungsschaltung 20 verbunden ist. Der dritte Spannungsanschluß 41 der zweiten Verrastungsschaltung 40 ist mit dem Emitteranschluß E verbunden, der vierte Spannungsanschluß 42 ist über einen Widerstand R7 mit dem Kollektoranschluß C der integrierten Schaltung verbunden. Der vierte Spannungsanschluß 42 ist ferner über eine Schutz-Zenerdiode 48 mit dem Emitteranschluß E der Schaltung verbunden, wobei der Minuspol der Zener Diode mit dem Widerstand R7 verbunden ist. Der weitere Ausgang 44 der zweiten Verrastungsschaltung 40 ist mit der Basis eines Transistors 12 verbunden, dessen Emitter mit dem Emitteranschluß der integrierten Schaltung und dessen Kollektor mit der Basis des Ansteuertransistors T4 verbunden ist. Der weitere Ausgang 44 ist ferner mit der Basis eines: Transistors T13 verbunden, dessen Emitter mit dem Emitteranschluß der integrierten Schaltung und dessen Kollektor mit dem Emitter des Ansteuertransistors T4 in Verbindung steht. Es ist außerdem ein zweiter Temperatursensor 45 vorgesehen, der an der Basis B angeschlossen ist. Dieser Temperatursensor liefert im gezeigten Ausführungsbeispiel ebenso wie der erste Temperatursensor 25 einen mit zunehmender Temperatur größer werdenen Strom. Der Temperatursensor 45 ist ferner mit der Basis eines Transistors T15 verbunden, dessen Kollektor einerseits mit einem Widerstand R8 verbunden ist, der wiederum mit der Basis B in Verbindung steht. Der Emitter des Transistors T15 ist mit dem Emitteranschluß der integrierten Schaltung verbunden. Der Kollektor des Transistors T15 steht in Kontakt mit der Basis eines Transistors T14, der mit seinem Kollektor an dem weiteren Ausgang 44 der zweiten Verrastungsschaltung 40 angeschlossen ist und dessen Emitter mit dem Emitteranschluß E der integrierten Schaltung verbunden ist.

Die zweite Verrastungsschaltung 40 dient dazu, beim ersten Anfahren der Übertemperatursicherung des Leistungstransistors, die durch die erste Verrastungsschaltung und den ersten Temperatursensor gegeben ist diesen abzuschalten und so zu verriegeln, daß auch bei einem Flankenwechsel am Basisanschluß der integrierten Schaltung, also nach einem Aus- und wieder Einschalten, die Übertemperaturabschaltung nicht rückgängig gemacht wird, solange die Temperatur des Leistungstransistors oberhalb einer unteren Temperaturschwelle liegt (Hysterese). Die zweite Verrastungschaltung gewährleistet dies ohne zusätzliche Versorgungsklemmen. Die Schaltung nach Figur 4 weist ebenso wie die Schaltung nach Figur 1 oder Figur 2 nur drei Anschlüsse, nämlich Basis-, Kollektor- und Emitteranschluß auf. Wird die Übertemperaturabschaltung durch die erste Verrastungsschaltung aktiv, so wird diese Information über den Transistor T11 an die zweite Verrastungsschaltung 40 weitergegeben, die in zur ersten Verrastungsschaltung analogern Weise als RS-Flip-Flop-Schaltung ausgestaltbar ist. Dadurch werden in analogen Weise zum Transistor T6 und Transistor T9 bei Überschreiten der oberen Temperaturschwelle die Transistoren T12 und T13 aktiv. Im Unterschied zum zweiten Spannungsanschluß 22 der ersten Verrastungsschaltung 20 ist der vierte Spannungsanschluß der zweiten Verrastungsschaltung 40 nicht am Basisanschluß B angeschlossen, sondern (über einen Widerstand R7) an den Kollektoranschluß C. Dabei schützt die Schutz-Zenerdiode 48 die zweite Verrastungschaltung vor Spannungen beispielsweise größer als 10 Volt. Nach einer Übertemperaturabschaltung erfolgt nach einem Flankenwechsel an Basisanschluß ein Reset der ersten Verrastungsschaltung, wodurch die Transistoren T6 und T9 in den sperrenden Zustand übergehen und somit der Leistungstransistor wieder über den Basisanschluß B angesteuert werden könnte, wenn nun nicht über die Transistoren T12 und T13 die Abschaltung aufrecht erhalten würde. Die zweite Verrastungsschaltung 40 nämlich hat noch kein Reset erfahren und ist am Ausgang 44 noch nicht wieder in die Vorzugslage "low" zurückgekehrt. Erst wenn eine untere Temperaturschwelle unterschritten worden ist, die kleiner ist als die obere Temperaturschwelle und die vom zweiten Temperatursensor 45 detektiert wird, geht der Transistor T15 vom leitenden in den gesperrten Zustand über. Der Transistor T14 verhält sich komplementär zu T15 und setzt bei angesteuertem Basisanschluß B der integrierten Schaltung die Basen der Transistoren T12 und T13 auf "Low" d.h. sie werden abgeschaltet, so daß der Leistungstransistor wieder über den Ansteuertransistor T4 ansteuerbar ist. Solange hingegen die Temperatur des Bauelements oberhalb der unteren Temperaturschwelle liegt, liefert der zweite Temperatursensor so viel Strom, daß T15 leitet beziehungsweise T14 sperrt und somit die Transistoren T12 und T13 in leitendem Zustand verharren.

Betrachtet man einen Zyklus des Bauelements mit Hochheizen (a), Abschalten (b), Abkühlen (c) und Wiedereinschalten (d), so treten folgende Schaltzustände auf:
a. Der Basisanschluß B wird angesteuert, der Transistor T4 ist leitend und versorgt den Leistungs-Darlington T1, T2, T3 mit Basisstrom. Dieser läuft unter Aufnahme hoher Verlustleistung in eine in der Figur 4 nicht explizit, dargestellte Strombegrenzung. Der erste Temperatursensor, der Transistor T6 und der Transistor T9 sowie der Transistor T12 und der Transistor T13 sind zunächst nicht aktiv. Der zweite Temperatursensor und der Transistor T15 sind unterhalb der unteren Temperaturschwelle inaktiv, oberhalb aktiv. Aktiv bedeutet bei den Transistoren dabei, daß sie in den leitenden Zustand geschaltet sind; aktiv bei den Temperatursensoren bedeutet, daß sie einen großen Strom aufgrund einer hohen detektierten Temperatur liefern. Der Transistor T14 verhält sich komplementär zu T15. Die erste und die zweite Verrastungsschaltung sind also an ihren Ausgängen 24 beziehungsweise 44 in der Vorzugslage "low".
b. Der erste Temperatursensor schaltet über den Widerstand R4 und den Transistor T10 die erste Verrastung. Dadurch werden die Transistoren T6, T9 und T11 aufgesteuert, der Leistungstransistor schaltet ab und die zweite Verrastung kippt auch. Die Transistoren T12 und T13 werden daher ebenfalls aufgesteuert. Der Basisstrom der Transistoren T12 und T13 wird über die zweite Verrastungschaltung vom Kollektoranschluß C geliefert.
c. Der Leistungstransistor kühlt wieder ab. Erfolgt nun ein Flankenwechsel am Basisanschluß B oberhalb der unteren Temperaturschwelle, so ergibt sich nachstehende Situation: Die erste Verrastung wird in die Vorzugslage zurückgesetzt, die Transistoren T6, T9 und T11 sperren. Die zweite Verrastung bleibt gekippt, da sie vom Kollektoranschluß C durchgehend versorgt ist. Die Transistoren T12, T13' T15 sind leitend. Der Transistor T14 sperrt, der Ausgang der zweiten Verrastung bleibt "high". Der Leistungstransistor kann noch nicht wieder eingeschaltet werden.
d. Wird die untere Temperaturschwelle durch die Bauelementtemperatur unterschritten, so wird der zweite Temperatursensor inaktiv, T15 sperrt, T14 leitet bei angesteuertem Basisanschluß B. Dadurch werden die Transistoren T12 und T13 gesperrt und der Eingang B' des Leistungstransistors wird freigegeben. Das Potential am Kollektoranschluß C geht bei induktiver Last (Zündspule) gegen Null, die zweite Verrastung wird dadurch gleichfalls in die Vorzugslage zurückgesetzt. Damit ist der Zyklus abgeschlossen.

Der zweite Temperatursensor der für einen anderen Bereich z.B. 150° C ausgelegt ist als der erste Temperatursensor, kann auf einem völlig anderen Prinzip, z.B. der Auswertung einer Diodenflußkennlinie beruhen. Der beschriebene Zyklus verdeutlicht, daß mit der in der Figur 4 dargestellten Schaltung die monolithische Integration eines anspruchsvollen Übertemperaturschutzes in einem dreipoligen Leistungstransistor ermöglicht wird, der unter Verwendung der Kollektorspannung die Abschaltinformation im Übertemperaturfalle über den Flankenwechsel am Eingang hinweg aufrechterhält.

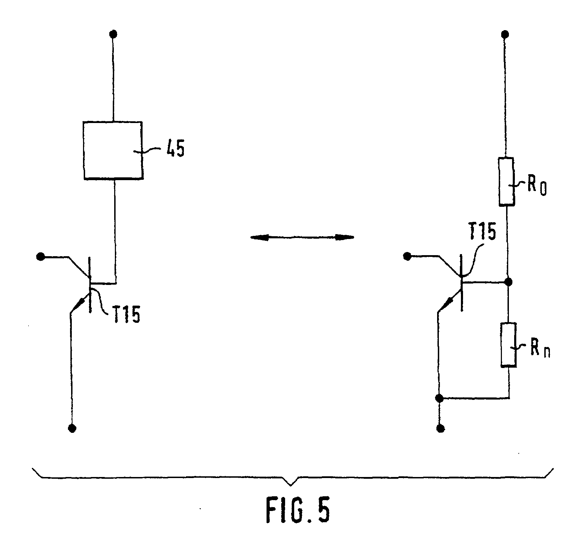

Figur 5 zeigt links den aus Transistor T15 und zweiten Temperatursensor 45 gebildeten Dreipol, wie er in Figur 4 verwendet wird. Dieser Dreipol kann in einer einfachen Ausführungsform durch einen Dreipol gebildet werden, wie er auf der rechten Seite der Figur 5 dargestellt ist. Hier'ist ein Widerstand Ro und ein Widerstand Rn in Reihe geschaltet, der Abgriff des Spannungsteilers ist mit der Basis des Transistors T15 verbunden. Der Widerstand Rn ist der Basis-Emitter-Strecke des Transistors T15 parallelgeschaltet, der Widerstand Ro ist mit dem in Figur 4 dargestellten Basisanschluß B verbunden. Am Widerstand Rn fällt eine temperaturabhängige Spannung ab, die (beispielsweise bei einem Schaltpunkt von 150 Grad Celsius) bei einer Toleranz der Spannung am Basisanschluß B von plus/minus fünf Prozent eine Bandbreite von ca. plus/minus 25 mV aufweist, was ca. plus/minus 10 Grad Kelvin entspricht. Das ist für die Anwendung ausreichend. Beim Einschalten des Leistungstransistors sinkt die Spannung an B etwas ab infolge des Innenwiderstands der Quelle des an B anliegenden Signals, wodurch das Schalten des Transistors T15 unterstützt wird.

## Patentansprüche

1. Integrierte Schaltung (10) mit einem Leistungstransistor (T1, T2, T3) und einer temperaturabhängig arbeitenden, mit dem Leistungstransistor thermisch gekoppelten Schaltungsanordnung (14), **dadurch gekennzeichnet, daß** die Schaltungsanordnung eine erste Verrastungsschaltung (20) aufweist, die über einen ersten Temperatursensor (25) ansteuerbar ist, wobei oberhalb einer oberen Temperaturschwelle durch ein Temperatursignal des ersten Temperatursensors (25) eine Abschaltung des Leistungstransistors auslösbar ist, und daß die Abschaltung bei Unterschreiten der oberen Temperaturschwelle erst durch ein an der Verrastungssschaltung anliegendes Steuersignal deaktivierbar ist, wobei die Schaltung einen Basis- (B), einen Kollektor- (C) und einen Emitteranschluß (E) aufweist, wobei der Kollektor- und der Emitteranschluß mit dem Kollektor bzw. dem Emitter des Leistungstransistors (T1, T2, T3) verbunden ist, und daß das Steuersignal durch ein an dem Basisanschluß (B) der integrierten Schaltung anliegendes Signal gebildet ist, wobei ein erster und ein zweiter Spannungsanschluß (21 und 22) der ersten Verrastungsschaltung (20) mit dem Emitter- (E) bzw. dem Basisanschluß (B) der integrierten Schaltung (10) verbunden sind, wobei eine zweite Verrastungsschaltung (40) die Abschaltinformation aus der ersten Verrastungsschaltung übernimmt und ein Wiedereinschalten des Leistungstransistors vor Unterschreiten einer durch einen Temperatursensor detektierten unteren Temperaturschwelle verhindert, wobei ein dritter und ein vierter Spannungsanschluß (41 und 42) der zweiten Verrastungsschaltung (40) mit dem Emitter- bzw. über einen weiteren Widerstand (R7) mit dem Kollektoranschluß der integrierten Schaltung verbunden sind, so daß die zweite Verrastungsschaltung über den Emitterbzw. Kollektoranschluß mit elektrischer Energie versorgt wird.

2. Integrierte Schaltung nach Anspruch 1, **dadurch gekennzeichnet, daß** durch einen Flankenwechsel am Basisanschluß (B) der integrierten Schaltung die erste Verrastungsschaltung (20) deaktivierbar ist.

3. Integrierte Schaltung nach einem der vorhergehenden Ansprüche, **dadurch gekennzeichnet, daß** die Schaltungsanordnung einen Funkenunterdrückungsteil (T7, T8, R5, R6) aufweist, wobei der Funkenunterdrückungsteil mit dem am Basisanschluß der integrierten Schaltung anliegenden Signal angesteuert wird, wobei bei einem Abschalten des Leistungstransistors durch die erste Verrastungsschaltung ein Überschreiten eines Grenzwertes der Spannung am Kollektoranschluß (C ) durch den Funkenunterdrückungsteil unterbunden wird.

4. Integrierte Schaltung nach Anspruch 3, **dadurch gekennzeichnet, daß** zwischen Kollektor- und Emitteranschluß ein Spannungsteiler (R5, R6) geschaltet ist, dessen Abgriff mit der Basis eines weiteren Transistors (T7) verbunden ist, wobei der Kollektor des weiteren Transistors (T7) mit dem Kollektoranschluß und der Emitter des weiteren Transistors (T7) mit dem Emitter eines Teiltransistors (T1) des Leistungstransistors (T1, T2, T3) verbunden ist.

5. Integrierte Schaltung nach Anspruch 4, **dadurch gekennzeichnet, daß** die Basis des weiteren Transistors (T7) über die Kollektor-Emitter-Strecke eines weiteren Transistors (T8) mit dem Emitteranschluß der integrierten Schaltung verbunden ist und daß die Basis des weiteren Transistors (T8) mit dem Basisanschluß der integrierten Schaltung verbunden ist.

6. Integrierte Schaltung nach einem der vorhergehenden Ansprüche, **dadurch gekennzeichnet, daß** ein Ansteuertransistor (T4) vorgesehen ist, dessen Kollektor mit dem Basisanschluß (B) der integrierten Schaltung, dessen Emitter mit der Basis des Teiltransistors (T1) des Leistungstransistors (T1, T2, T3) verbunden ist und über den ein Basisstrom des Leistungstransistors fließt.

7. Integrierte Schaltung nach Anspruch 1, **dadurch gekennzeichnet, daß** die zweite Verrastungsschaltung einen weiteren Eingang (43) aufweist, der über einen weiteren Transistor (T11) mit einem Ausgang der ersten Verrastungsschaltung (20) verbunden ist.

8. Integrierte Schaltung nach Anspruch 6 und einem der Ansprüche 1 oder 7, **dadurch gekennzeichnet, daß** die zweite Verrastungsschaltung einen weiteren Ausgang (44) aufweist, der mit der Basis eines weiteren Transistors (T12) verbunden ist, wobei der Kollektor des weiteren Transistors (T12) mit der Basis des Ansteuertransisitors (T4) verbunden ist.

9. Integrierte Schaltung nach Anspruch 8, **dadurch gekennzeichnet, daß** die Basis eines weiteren Transistors (T13) mit dem weiteren Ausgang (44) verbunden ist, wobei der Kollektor des weiteren Transistors (T13) mit dem Emitter des Ansteuertransistors (T4) verbunden ist.

10. Integrierte Schaltung nach Anspruch 8 oder 9, **dadurch gekennzeichnet, daß** ein zweiter Temperatursensor (45) über eine Transistorverknüpfung (T14, T15) mit dem weiteren Ausgang (44) der zweiten Verrastungsschaltung (40) verbunden ist, wobei im Falle einer Ansteuerung des weiteren Transistors (T12) bei Unterschreiten der durch den zweiten Temperatursensor detektierten unteren Temperaturschwelle die Ansteuerung zurückgenommen wird.

11. Integrierte Schaltung nach einem der vorhergehenden Ansprüche, **dadurch gekennzeichnet, daß** der Ausgang (24) der ersten Verrastungsschaltung mit der Basis eines Transistors (T6) verbunden ist, dessen Kollektorstrom eine Änderung des Basistroms des Leistungstransistors auslöst.

12. Integrierte Schaltung nach Anspruch 6 und 11, dadurch ekennzeichnet, daß der Kollektor des Transistors (T6) mit der Basis des Ansteuertransistors (T4) verbunden ist.

13. Integrierte Schaltung nach einem der vorhergehenden Ansprüche, **dadurch gekennzeichnet, daß** der Ausgang (24) der ersten Verrastungsschaltung mit der Basis eines weiteren Transistors (T9) verbunden ist, dessen Kollektor mit der Basis (B') des Teiltransistors (T1) und dessen Emitter mit dem, Emitteranschluß (E) der integrierten Schaltung verbunden ist.

14. Integrierte Schaltung nach einem der vorhergehenden Ansprüche, **dadurch gekennzeichnet, daß** die erste Verrastungsschaltung eine RS-Flipflop-Schaltung aufweist.

15. Integrierte Schaltung nach Anspruch 1, **dadurch gekennzeichnet, daß** die zweite Verrastungsschaltung eine weitere RS-Flipflop-Schaltung aufweist.

16. Integrierte Schaltung nach Anspruch 14, **dadurch gekennzeichnet, daß** die Spannungsversorgung des Flipflops der ersten Verrastungsschaltung über den ersten und zweiten Spannungsanschluß (21 beispielsweise 22) durch die Basis-Emitter-Spannung der integrierten Schaltung gegeben ist, daß der zweite Spannungsanschluß (22) mit dem Reset-Eingang des RS-Flipflops, der Eingang (23) mit dem Set-Eingang des RS-Flipflops und der Ausgang (24) mit dem Q-Ausgang des RS-Flipflops verbunden ist.

17. Integrierte Schaltung nach Anspruch 15, **dadurch gekennzeichnet, daß** die Spannungsversorgung des weiteren Flipflops der zweiten Verrastungsschaltung über den dritten und vierten Spannungsanschluß (41 beispielsweise 42) durch die Kollektor-Emitter-Spannung der integrierten Schaltung gegeben ist, daß der vierte Spannungsanschluß (42) mit dem Reset-Eingang des weiteren RS-Flipflops, der weitere Eingang (43) mit dem Set-Eingang des weiteren RS-Flipflops und der Ausgang (44) mit dem Q-Ausgang des weiteren RS-Flipflops verbunden ist.

18. Integrierte Schaltung nach einem der vorhergehenden Ansprüche, **dadurch gekennzeichnet daß** der erste Temperatursensor einen Sensortransistor (T5) aufweist, dessen Basis-Emitter-Strecke mit einem temperaturabhängigen Sensorwiderstand (R3) mit positivem Temperaturkoeffizienten beschaltet ist.

## Claims

1. Integrated circuit (10) having a power transistor (T1, T2, T3) and a circuit arrangement (14) which operates in a temperature-dependent manner and is thermally coupled to the power transistor, **characterized in that** the circuit arrangement has a first latching circuit (20), which can be driven via a first temperature sensor (25), it being possible for a turn-off of the power transistor to be triggered above an upper temperature threshold by a temperature signal of the first temperature sensor (25), and **in that** the turn-off can only be deactivated, when the upper temperature threshold is undershot, by a control signal present at the latching circuit, the circuit having a base terminal (B), a collector terminal (C) and an emitter terminal (E), the collector terminal and the emitter terminal being connected to the collector and to the emitter, respectively, of the power transistor (T1, T2, T3), and **in that** the control signal is formed by a signal present at the base terminal (B) of the integrated circuit, a first and a second voltage terminal (21 and 22) of the first latching circuit (20) being connected to the emitter terminal (E) and to the base terminal (B), respectively, of the integrated circuit (10), a second latching circuit (40) accepting the turn-off information from the first latching circuit and preventing the power transistor from turning on again before a lower temperature threshold deflected by a temperature sensor is undershot, a third and a fourth voltage terminal (41 and 42) of the second latching circuit (40) being connected to the emitter terminal and, respectively, via a further resistor (R7) to the collector terminal of the integrated circuit, with the result that the second latching circuit is supplied with electrical energy via the emitter terminal and collector terminal.

2. Integrated circuit according to Claim 1, **characterized in that** the first latching circuit (20) can be deactivated by an edge change at the base terminal (B) of the integrated circuit.

3. Integrated circuit according to one of the preceding claims, **characterized in that** the circuit arrangement has a spark suppression section (T7, T8, R5, R6), the spark suppression section being driven by the signal present at the base terminal of the integrated circuit, and, in the event of a turn-off of the power transistor by the first latching circuit, the spark suppression section preventing a limit value of the voltage at the collector terminal (C) from being exceeded.

4. Integrated circuit according to Claim 3, **characterized in that** a voltage divider (R5, R6) is connected between the collector and emitter terminals, the tap of which voltage divider is connected to the base of a further transistor (T7), the collector of the further transistor (T7) being connected to the collector terminal and the emitter of the further transistor (T7) being connected to the emitter of a transistor element (T1) of the power transistor (T1, T2, T3).

5. Integrated circuit according to Claim 4, **characterized in that** the base of the further transistor (T7) is connected to the emitter terminal of the integrated circuit via the collector-emitter path of a further transistor (T8), and **in that** the base of the further transistor (T8) is connected to the base terminal of the integrated circuit.

6. Integrated circuit according to one of the preceding claims, **characterized in that** a drive transistor (T4) is provided, whose collector is connected to the base terminal (B) of the integrated circuit, and whose emitter is connected to the base of the transistor element (T1) of the power transistor (T1, T2, T3) and via which a base current of the power transistor flows.

7. Integrated circuit according to Claim 1, **characterized in that** the second latching circuit has a further input (43), which is connected to an output of the first latching circuit (20) via a further transistor (T11),

8. Integrated circuit according to Claim 6 and either of Claims 1 and 7, **characterized in that** the second latching circuit has a further output (44), which is connected to the base of a further transistor (T12), the collector of the further transistor (T12) being connected to the base of the drive transistor (T4).

9. Integrated circuit according to Claim 8, **characterized in that** the base of a further transistor (T13) is connected to the further output (44) the collector of the further transistor (T13) being connected to the emitter of the drive transistor (T4).

10. Integrated circuit according to Claim 8 or 9, **characterized in that** a second temperature sensor (45) is connected to the further output (44) of the second latching circuit (40) via a transistor combination (T14, T15), the driving being withdrawn in the case of driving of the further transistor (T12) when the lower temperature threshold detected by the second temperature sensor is undershot.

11. Integrated circuit according to one of the preceding claims, **characterized in that** the output (24) of the first latching circuit is connected to the base of a transistor (T6), whose collector current triggers a change in the base current of the power transistor.

12. Integrated circuit according to Claims 6 and 11, **characterized in that** the collector of the transistor (T6) is connected to the base of the drive transistor (T4).

13. Integrated circuit according to one of the preceding claims, **characterized in that** the output (24) of the first latching circuit is connected to the base of a further transistor (T9), whose collector is connected to the base (B') of the transistor element (T1) and whose emitter is connected to the emitter terminal (E) of the integrated circuit.

14. Integrated circuit according to one of the preceding claims, **characterized in that** the first latching circuit has an RS flip-flop circuit.

15. Integrated circuit according to Claim 1, **characterized in that** the second latching circuit has a further RS flip-flop circuit.

16. Integrated circuit according to Claim 14, **characterized in that** the voltage supply of the flip-flop of the first latching circuit is provided via the first and second voltage terminal (21 for example 22) by the base-emitter voltage of the integrated circuit, and **in that** the second voltage terminal (22) is connected to the reset input of the RS flip-flop, the input (23) is connected to the set input of the RS flip-flop, and the output (24) is connected to the Q output of the RS flip-flop.

17. Integrated circuit according to Claim 15, **characterized in that** the voltage supply of the further flip-flop of the second latching circuit is provided via the third and fourth voltage terminals (41 for example 42) by the collector-emitter voltage of the integrated circuit, and **in that** the fourth voltage terminal (42) is connected to the reset input of the further RS flip-flop, the further input (43) is connected to the set input of the further RS flip-flop, and the output (44) is connected to the Q output of the further RS flip-flop.

18. Integrated circuit according to one of the preceding claims, **characterized in that** the first temperature sensor has a sensor transistor (T5), whose base-emitter junction is connected up to a temperature-dependent sensor resistor (R3) with a positive temperature coefficient.

## Revendications

1. Circuit intégré (10) comportant un transistor de puissance (T1, T2, T3) et un circuit (14) couplé thermiquement au transistor de puissance et fonctionnant suivant la température,
**caractérisé en ce qu'**
un premier circuit d'accrochage (20) est commandé par un premier capteur de température (25), et au-dessus d'un seuil de température supérieur, un signal de température du premier capteur de température (25) déclenche la coupure du transistor de puissance, et
la coupure est neutralisée lorsqu'on passe en dessous du seuil de température supérieur seulement si un signal de commande est appliqué au circuit d'accrochage,
le circuit ayant une borne de base (B), une borne de collecteur (C) et une borne d'émetteur (E), la borne de collecteur et celle d'émetteur étant reliées au collecteur et à l'émetteur du transistor de puissance (T1, T2, T3),
le signal de commande est formé par un signal appliqué à la borne de base (B) du circuit intégré, une première et une seconde borne de tension (21, 22) du premier circuit d'accrochage (20) étant reliées à la borne d'émetteur (E) et la borne de base (B) du circuit intégré (10), et
un second circuit d'accrochage (40) reçoit l'information de coupure du premier circuit d'accrochage et interdit le déblocage du transistor de puissance avant le passage en dessous d'un seuil de température supérieur détecté par un capteur de température,
une troisième et une quatrième borne de tension (41, 42) du second circuit d'accrochage (40) étant reliées à la borne d'émetteur ou à une autre résistance (R7) avec la borne de collecteur du circuit intégré de façon que le second circuit d'accrochage reçoive l'énergie électrique par la borne d'émetteur ou de collecteur.

2. Circuit intégré selon la revendication 1,
**caractérisé en ce qu'**
un changement de flanc appliqué à la borne de base (B) du circuit intégré, neutralise le premier circuit d'accrochage (20).

3. Circuit intégré selon l'une quelconque des revendications précédentes,
**caractérisé en ce qu'**
il comporte une partie de suppression d'étincelle (T7, T8, R5, R6), cette partie étant commandée par le signal appliqué à la borne de base du circuit intégré, et
lors de la coupure du transistor de puissance par le premier circuit d'accrochage, la partie de suppression d'étincelle interdit le dépassement d'une valeur limite de la tension à la borne de collecteur (C).

4. Circuit intégré selon la revendication 3,
**caractérisé en ce qu'**
un diviseur de tension (R5, R6) est branché entre la borne de collecteur et celle d'émetteur, la prise du diviseur de tension étant reliée à la base d'un autre transistor (T7), et le collecteur de cet autre transistor (T7) est relié à la borne de collecteur, l'émetteur de cet autre transistor (T7) étant relié à l'émetteur d'un transistor partiel (T1) du transistor de puissance (T1, T2, T3).

5. Circuit intégré selon la revendication 4,
**caractérisé en ce que**
la base de l'autre transistor (T7) est reliée par le chemin collecteur-émetteur d'un autre transistor (T8) à la borne d'émetteur du circuit intégré et la base de cet autre transistor (T8) est reliée à la borne de base du circuit intégré.

6. Circuit intégré selon l'une quelconque des revendications précédentes,
**caractérisé par**
un transistor de commande (T4) dont le collecteur est relié à la borne de base (B) du circuit intégré et dont l'émetteur est relié à la base du transistor partiel (T1) appartenant au transistor de puissance (T1, T2, T3) et par lequel passe le courant de base du transistor de puissance.

7. Circuit intégré selon la revendication 1,
**caractérisé en ce que**
le second circuit d'accrochage comporte une autre entrée (43) reliée par un autre transistor (T11) à une sortie du premier circuit d'accrochage (20).

8. Circuit intégré selon la revendication 6 ou l'une des revendications 1 ou 7,
**caractérisé en ce que**
le second circuit d'accrochage comporte une autre sortie (44) reliée à la base d'un autre transistor (T12), le collecteur de ce transistor (T12) étant relié à la base du transistor de commande (T4).

9. Circuit intégré selon la revendication 8,
**caractérisé en ce que**
la base d'un autre transistor (T13) est reliée à l'autre sortie (44) et le collecteur de cet autre transistor (T13) est relié à l'émetteur du transistor de commande (T4).

10. Circuit intégré selon l'une quelconque des revendications 8 ou 9,
**caractérisé en ce qu'**
un second capteur de température (45) est relié par une combinaison de transistors (T14, T15) à l'autre sortie (44) du second circuit d'accrochage (40), et en cas de commande de l'autre transistor (T12) lors du dépassement vers le bas du seuil de température inférieur, détecté par le second capteur de température, la commande est neutralisée.

11. Circuit intégré selon l'une quelconque des revendications précédentes,
**caractérisé en ce que**
la sortie (24) du premier circuit d'accrochage est reliée à la base d'un transistor (T6) dont le courant de collecteur déclenche une modification de base du transistor de puissance.

12. Circuit intégré selon l'une quelconque des revendications 6 et 11,
**caractérisé en ce que**
le collecteur du transistor (T6) est relié à la base du transistor de commande (T4).

13. Circuit intégré selon l'une quelconque des revendications précédentes,
**caractérisé en ce que**
la sortie (24) du premier circuit d'accrochage est reliée à la base d'un autre transistor (T9) dont le collecteur est relié à la base (B') du transistor partiel (T1) et dont l'autre émetteur est relié à la borne d'émetteur (E) du circuit intégré.

14. Circuit intégré selon l'une quelconque des revendications précédentes,
**caractérisé en ce que**
le premier circuit d'accrochage est un Flip-Flop RS.

15. Circuit intégré selon la revendication 1,
**caractérisé en ce que**
le second circuit d'accrochage est un autre Flip-Flop RS.

16. Circuit intégré selon la revendication 14,
**caractérisé en ce que**
l'alimentation en tension du Flip-Flop du premier circuit d'accrochage se fait par la première et la seconde borne de tension (21, 22) par la tension de base-émetteur du circuit intégré, la seconde borne de tension (22) est reliée à l'entrée de remise à l'état initial reset du Flip-Flop RS, l'entrée (23) est reliée à l'entrée de mise à l'état Set du Flip-Flop et la sortie (24) est reliée à la sortie Q du Flip-Flop RS.

17. Circuit intégré selon la revendication 15,
**caractérisé en ce que**
l'alimentation en tension de l'autre Flip-Flop du second circuit d'accrochage est relié par la troisième et la quatrième borne de tension (41, 42) qui donne la tension au collecteur-émetteur du circuit intégré,
la quatrième borne de tension (42) est reliée à l'entrée reset de l'autre Flip-Flop RS, l'autre entrée (43) est reliée à l'entrée de mise à l'état Set de l'autre Flip-Flop RS et la sortie (44) est reliée à la sortie Q de cet autre Flip-Flop RS.

18. Circuit intégré selon l'une quelconque des revendications précédentes,
**caractérisé en ce que**
le premier capteur de température comporte un transistor capteur (T5) dont le chemin de base-émetteur est relié à une résistance (R3) dépendante de la température et ayant un coefficient de température positif.
